# EUROPEAN PATENT APPLICATION

(11) **EP 4 618 723 A2**
(43) Date of publication of application: **17.09.2025**
(21) Application number: 25162966.3
(22) Date of filing: 11.03.2025
(51) Int. Cl.: H10D 64/01, H10D 30/01, H10D 64/68

(54) **SEMICONDUCTOR MEMORY DEVICE INCLUDING FERROELECTRIC CAPACITOR AND MANUFACTURING METHOD THEREOF**

(30) Priority: 15.03.2024 KR 20240036386; 27.06.2024 KR 20240084144; 09.09.2024 KR 20240122501; 15.11.2024 KR 20240162679
(71) Applicant: Korea Advanced Institute of Science and Technology, Daejeon 34141 (KR)
(72) Inventor: CHO, Byung Jin, 34141 Daejeon (KR); PARK, YoungKeun, 34141 Daejeon (KR); JEONG, Jaejoong, 34141 Daejeon (KR); CHU, Jun Hong, 34141 Daejeon (KR); KIM, Sheunghun, 34141 Daejeon (KR); KANG, Daehyun, 34141 Daejeon (KR)
(74) Representative: Mathys & Squire

(57) **Abstract**

The present invention relates to a semiconductor memory device including a ferroelectric capacitor (400) and a manufacturing method thereof, and more particularly, to a semiconductor memory device capable of preventing electrons from being captured in an interface layer (IL) by adding a ferroelectric capacitor (400) to a location where an oxide filler is formed inside a channel structure (300) and forming the ferroelectric capacitor between the channel structure, wherein the ferroelectric capacitor includes a ferroelectric thin film (410) and a metal coating (420), and a manufacturing method thereof.

## Description

### CROSS-REFERENCE TO RELATED APPLICATIONS

This application claims priority under 35 U.S.C. §119 to Korean Patent Application No. 10-2024-0036386, filed on March 15th, 2024, and No. 10-2024-0122501, filed on September 15th, 2024, and No. 10-2024-0162679, filed on November 15th, 2024, in the Korean Intellectual Property Office, the disclosure of which is incorporated herein by reference in its entirety.

### TECHNICAL FIELD

The following disclosure relates to a 3D semiconductor memory device including a ferroelectric capacitor and a manufacturing method thereof, and more particularly, to a 3D semiconductor memory device including a ferroelectric capacitor in which the ferroelectric capacitor is added to a location where an oxide filler is formed inside a channel structure, and a manufacturing method thereof.

### BACKGROUND

Currently, the demand for memory semiconductors is increasing explosively due to the 4th industrial revolution. As Internet-on-Things (IoT) devices are increasing explosively, the demand for memory is increasing in an edge device including a smartphone, and the amount of data that should be handled is increasing explosively as deep learning is utilized.

In order to keep up with this technological trend, nonvolatile memory semiconductors require high integration and excellent memory performance, and 3D NAND flash memory is leading the nonvolatile memory market because it is far superior to other methods in terms of device integration.

The 3D NAND flash memory is not only playing the role of nonvolatile memory, but is also attracting attention as a computing-in-memory (CIM) device for the upcoming AI era. The CIM device are devices that perform a multiply and accumulation (MAC) operation, a core operation of deep learning, at the memory level, and may operate more efficiently because frequent data transfer between logic and memory is reduced.

In the latest trend of the devices that cause the memory to perform the operation, it is more essential than ever to perform memory read, write, and erase operations of the memory as quickly as possible and store a large amount of information (e.g., 3 bits/cell) in a single device.

The process technology of the 3D NAND flash memory has been developed in a direction of Z-scaling which laminates cells along the z-axis while reducing a gap between word lines to reduce the given height. The integration through the Z-scaling helps secure more layers by reducing the gap between cells, but XY-scaling, which reduces the cell diameter, should be accompanied to increase gate controllability to suppress the short channel effect.

However, there is a limit to reducing the cell diameter, and there is a problem that reducing the cell diameter causes deterioration of memory window and data retention performance.

Meanwhile, dual mechanism memory devices have a memory window that is more than twice that of the existing charge capture flash memory devices because residual polarization of a ferroelectric and charges captured in a charge capture layer cause a change in threshold voltage in the same direction. This may solve the reliability degradation problem that occurs when applying a quad level cell (QLC).

However, there is a disadvantage in that the existing FeFET memory device including such ferroelectric has a short lifespan because the ferroelectric is formed between the laminated structure and the channel and electrons are gradually captured by the interface layer (IL) formed between the ferroelectric and the channel. In addition, there is a disadvantage in that the memory window is low at less than 3 V.

### SUMMARY

An embodiment of the present disclosure is directed to securing a wide memory window while lowering a threshold voltage regardless of XYZ-scaling by adding a ferroelectric capacitor to a memory cell, and forming a bottom electrode in a semiconductor memory and prevent electrons from being captured in an interface layer (IL) by forming a ferroelectric between a channel structure and the bottom electrode.

In one general aspect, a semiconductor memory device includes: a laminated structure that includes word lines and inter layer dielectrics laminated on a substrate alternately and repeatedly; a channel structure that penetrates through the laminated structure and is connected to the substrate; a vertical inter layer dielectric that is interposed between the laminated structure and the channel structure, and includes a tunnel layer in contact with the channel structure, a blocking layer in contact with the laminated structure, and a charge trap layer interposed between the tunnel layer and the blocking layer; and a ferroelectric capacitor that is connected to an inner side surface of the channel structure to form an electrode, in which the ferroelectric capacitor includes a ferroelectric thin film and a metal coating.

The ferroelectric capacitor may be formed such that one side of a ferroelectric thin film is connected to the channel structure, and the metal coating is connected to the other side of the ferroelectric thin film.

The ferroelectric thin film may include hafnium oxide (HfO₂), an insulating thin film in which at least one element of Al, Zr, La, Si, Gd, Sc, Y, Ge, N is included in the HfO₂, and at least one of zirconium oxide (ZrO₂), aluminum oxide (Al₂O₃), and barium strontium titanate (BST).

The metal coating may include at least one of titanium nitride (TiN), tantalum nitride (TaN), chromium nitride (CrN), zirconium nitride (ZrN), aluminum nitride (AlN), tungsten (W), tungsten nitride (WN), molybdenum (Mo), and molybdenum nitride (MO₂N).

A bias voltage of -5 V or higher and +5 V or lower may be applied to the ferroelectric capacitor.

The ferroelectric thin film may have a thickness of 10 nm or less.

In another general aspect, a semiconductor memory device connected to a positive terminal and a negative terminal of a power supply includes: a laminated structure connected to the positive terminal of the power supply and applied with a voltage; a vertical inter layer dielectric formed on a lower surface portion of the laminated structure; a channel structure formed on a lower surface portion of the vertical inter layer dielectric and connected to a substrate; a ferroelectric capacitor formed on a lower surface portion of the channel structure; and a bottom electrode formed on a lower surface portion of the ferroelectric capacitor and connected to the negative terminal of the power supply.

The ferroelectric capacitor may include a ferroelectric material based on HfO₂ (hafnium oxide).

A ferroelectric material based on the HfO₂ (hafnium oxide) may have a thickness greater than 0 nm and 30 nm or less.

The ferroelectric capacitor may include a perovskite-based ferroelectric material including at least one of PbTiO₃, SrTiO₃, and CaTiO₃.

The perovskite-based ferroelectric material including at least one of PbTiO₃, SrTiO₃, and CaTiO₃ may have a thickness greater than 0 nm and 100 nm or less.

The ferroelectric capacitor may include a two-dimensional material including at least one of α-In₂, Se₃, and SnS.

The channel structure may have a thickness greater than 0 nm and 100 nm or less.

The semiconductor memory device may further include: a first thin film formed between the channel structure and the ferroelectric capacitor; and a second thin film formed between the ferroelectric capacitor and the bottom electrode.

In still another general aspect, a manufacturing method of a semiconductor memory device includes: (a) forming a laminated structure by alternately laminating a word line and an inter layer dielectric; (b) forming a cylindrical hole in the laminated structure and forming a blocking layer on an inner circumferential surface of the hole; (c) forming a charge trap layer on an inner circumferential surface of the blocking layer; (d) forming a tunnel layer on an inner circumferential surface of the charge trap layer; (e) forming a channel structure on an inner circumferential surface of the tunnel layer; (f) forming a ferroelectric capacitor on an inner circumferential surface of the channel structure; and (g) removing a thin film layer included in the inter layer dielectric and depositing a metal along the word line to form a gate electrode.

The (f) may further include: (f-1) forming a ferroelectric thin film on the inner circumferential surface of the channel structure; and (f-2) forming a metal coating on an inner circumferential surface of the ferroelectric thin film.

In the (f-1), the ferroelectric thin film may include hafnium oxide (HfO₂), an insulating thin film in which at least one element of Al, Zr, La, Si, Gd, Sc, Y, Ge, N is included in the HfO₂, and at least one of zirconium oxide (ZrO₂), aluminum oxide (Al₂O₃), and barium strontium titanate (BST).

In the (f-2), the metal coating may include at least one of titanium nitride (TiN), tantalum nitride (TaN), chromium nitride (CrN), zirconium nitride (ZrN), aluminum nitride (AlN), tungsten (W), tungsten nitride (WN), molybdenum (Mo), and molybdenum nitride (Mo₂N).

### BRIEF DESCRIPTION OF THE DRAWINGS

FIG. 1 is a perspective cross-sectional view illustrating a configuration of a semiconductor memory device according to an embodiment of the present invention.
FIG. 2 is a plan view illustrating the configuration of the semiconductor memory device according to an embodiment of the present invention.
FIG. 3 is a flowchart illustrating a manufacturing sequence of the semiconductor memory device according to an embodiment of the present invention.
FIG. 4 is a plan view illustrating the configuration of the semiconductor memory device according to an embodiment of the present invention.
FIG. 5 is a plan view illustrating a configuration of a semiconductor memory device according to another embodiment of the present invention.
FIG. 6 is a graph showing a threshold voltage according to a thickness of a channel structure of the semiconductor memory device according to an embodiment of the present invention.

### [Detailed Description of Main Elements]

- 100:: Laminated structure
- 110:: Word line
- 120:: Inter layer dielectric
- 200:: Vertical inter layer dielectric
- 210:: Tunnel layer
- 220:: Charge trap layer
- 230:: Blocking layer
- 300:: Channel structure
- 400:: Ferroelectric capacitor
- 410:: Ferroelectric thin film
- 420:: Metal coating
- 500:: Bottom electrode
- 600_1:: First thin film
- 600_2:: Second thin film

### DETAILED DESCRIPTION OF EMBODIMENTS

The above-described objects, features, and advantages of the present disclosure will become more obvious from the following detailed description provided in relation to the accompanying drawings. The following specific structural or functional descriptions are only exemplified for the purpose of describing the embodiments according to the concept of the present invention, and the embodiments according to the concept of the present invention may be implemented in various forms and should not be construed as limited to the embodiments described herein or in the application. Since embodiments of the concept of the present disclosure may be variously modified and may have several forms, specific embodiments will be illustrated in the accompanying drawings and will be described in detail in the present specification or application. However, it is to be understood that the present disclosure is not limited to specific embodiments, but includes all modifications, equivalents, and substitutions falling in the spirit and the scope of the present disclosure. Terms such as 'first', 'second', or the like, may be used to describe various components, but these components are not to be construed as being limited to these terms. The terms are used only to distinguish one component from another component. For example, a first component may be named a second component and the second component may also be named the first component, without departing from the scope of the present invention. It is to be understood that when one component is referred to as being "connected to" or "coupled to" another component, it may be connected directly to or coupled directly to another component or be connected to or coupled to another component with the other component interposed therebetween. On the other hand, it is to be understood that when one component is referred to as being "connected directly to" or "coupled directly to" another component, it may be connected to or coupled to another component without the other component interposed therebetween. Other expressions for describing the relationship between components, such as between and immediately between or adjacent to and directly adjacent to, etc., should be interpreted similarly. Terms used in the present specification are used only in order to describe specific embodiments rather than limiting the present disclosure. Singular forms include plural forms unless the context clearly indicates otherwise. It is to be understood that terms "include," "have," or the like, used in the present specification specify the presence of features, numerals, steps, operations, components, parts, or a combination thereof described in the present specification, but do not preclude the presence or addition of one or more other features, numerals, steps, operations, components, parts, or a combination thereof. Unless indicated otherwise, it is to be understood that all the terms used in the specification including technical and scientific terms have the same meaning as those that are generally understood by those who skilled in the art. Terms generally used and defined in a dictionary are to be interpreted as the same meanings with meanings within the context of the related art, and are not to be interpreted as ideal or excessively formal meanings unless clearly indicated in the present specification. Hereinafter, exemplary embodiments of the present invention will be described in detail with reference to the accompanying drawings. The same reference numerals in each drawing denote the same components.

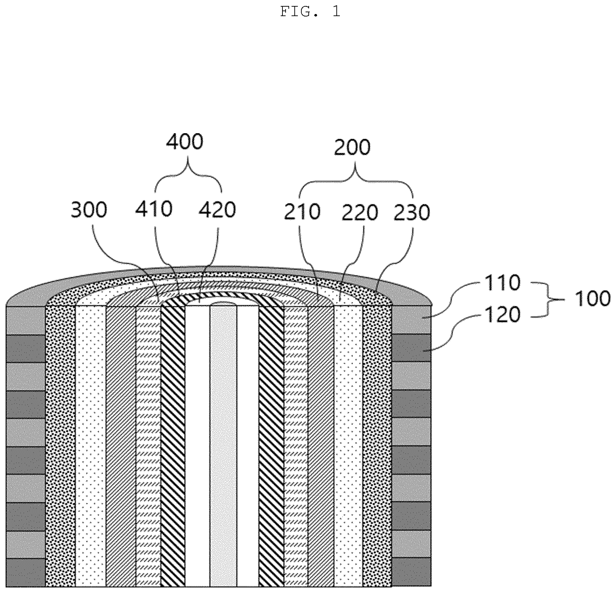

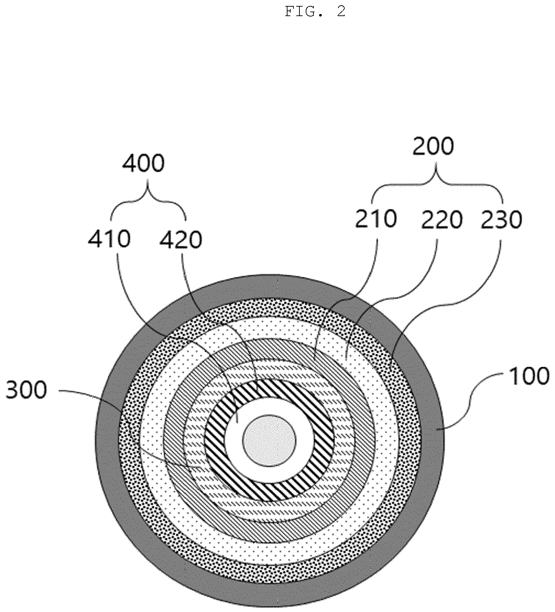

FIG. 1 is a perspective cross-sectional view illustrating a configuration of a semiconductor memory device according to an embodiment of the present invention, and FIG. 2 is a plan view illustrating the configuration of the semiconductor memory device according to an embodiment of the present invention.

Referring to FIGS. 1 and 2, the semiconductor memory device according to an embodiment of the present invention may include a laminated structure 100 that includes word lines 110 and inter layer dielectric 120, a channel structure 300 that penetrates through the laminated structure 100 and connected to a substrate, a tunnel layer 210 that is interposed between the laminated structure 100 and the channel structure 300 and in contact with the channel structure 300, a vertical inter layer dielectric 200 that includes a blocking layer 230 in contact with the laminated structure 100 and a charge trap layer 220 interposed between the tunnel layer 210 and the blocking layer 230, a ferroelectric capacitor 400 that is connected to an inner side surface of the channel structure 300 to form an electrode.

The laminated structure 100 may have the word line 110 and the inter layer dielectric 120 that are alternately and repeatedly laminated on the substrate. The word line 110 of the three-dimensional semiconductor memory may be repeatedly arranged in multiple layers in the laminated structure 100, and individually access memory cells of each layer. That is, the word line 110 may enable access specific cells in the laminated structure 100 in a vertical direction. The inter layer dielectric 120 may be located between the word lines 110 to prevent electrical interference between metal wirings. The inter layer dielectric 120 may be made of a material such as SiO₂ or SiCOH.

The channel structure 300 may include a polysilicon channel or an oxide semiconductor channel. The oxide semiconductor channel may include at least one of indium oxide (In₂O₃), zinc oxide (ZnO), gallium oxide (Ga₂O₃), indium zinc oxide (InZnO), zinc tin oxide (ZTO), and indium gallium zinc oxide (InGaZnO). The oxide semiconductor channel has characteristics of high electron mobility.

The vertical inter layer dielectric 200 may include a blocking layer 230, a charge trap layer 220, and a tunnel layer 210. The blocking layer 230 corresponds to a blocking layer portion of a charge trap memory device.

The charge trap layer 220 is located on the blocking layer 230 and is provided to trap charges injected from the laminated structure 100. This is because when a negative gate voltage is formed on the laminated structure 100, charges passing through the tunnel layer 210 are prevented from moving to the channel structure 300 by the blocking layer 230 to be captured on the charge trap layer 220.

The charge trap layer 220 is preferably silicon nitride (Si₃N₄), but may also be made of one or a combination of aluminum oxide, zirconium oxide, hafnium oxide, lanthanum oxide, and niobium oxide.

As described above, the tunnel layer 210 is provided such that when a negative gate voltage is applied to the laminated structure 100, the charges of the laminated structure 100 move to the charge trap layer 220 via the tunnel layer 210.

Such a tunnel layer 210 is provided as an energy barrier layer according to the tunneling of the charge, and is preferably made of an oxide film such as silicon oxide (SiO₂).

In addition, the process of forming the tunnel layer 210 is preferably performed by a thermal oxidation process or a radical oxidation process, and as described above, the thickness of the tunnel layer 210 is preferably formed to be smaller than the thickness of the blocking layer and equal to or smaller than the thickness of the charge trap layer 220, and the thickness of the tunnel layer 210 is preferably 5 nm to 10 nm, for example.

Meanwhile, the laminated structure 100 is located on an upper portion of the blocking layer 230 and is applied with an on-voltage and an off-voltage from a gate bias circuit. In the present invention, as described above, a negative gate voltage corresponds to an on-voltage, and when the negative gate voltage is applied, the charge of the laminated structure 100 moves to the charge trap layer 220 via the blocking layer 230.

It is preferable that the laminated structure 100 includes a conductive nitride such as TiN, TaN, and WN.

In addition, the laminated structure 100 may include a conductive oxynitride (e.g., TiON, etc.) or a combination thereof (e.g., TiSiN, TiAlON, etc.), and may include polysilicon heavily doped with impurities.

Of course, the laminated structure 10 may include a conductive metal such as platinum (Pt), ruthenium (Ru), iridium (Ir), silver (Ag), aluminum (Al), titanium (Ti), tantalum (Ta), tungsten (W), silicon (Si), copper (Cu), nickel (Ni), cobalt (Co), or molybdenum (Mo), or an alloy thereof, other than the nitride form as described above, and these materials are exemplary, and the present invention is not limited thereto.

Meanwhile, a center of the channel structure 300 is generally formed with an oxide filler, and the semiconductor memory device according to the present invention may include a ferroelectric capacitor 400 at a location where the oxide filler is located. The ferroelectric capacitor 400 may be connected to an inner side surface of the channel structure 300 to form an electrode. The ferroelectric capacitor 400 may include a ferroelectric thin film 410 and a metal coating 420. The ferroelectric thin film may include hafnium oxide (HfO₂) which is ferroelectric, an insulating thin film in which at least one element of Al, Zr, La, Si, Gd, Sc, Y, Ge, N is included in the HfO₂, and at least one of zirconium oxide (ZrO₂), aluminum oxide (Al₂O₃), and barium strontium titanate (BST).

The metal coating 420 may include at least one of titanium nitride (TiN), tantalum nitride (TaN), chromium nitride (CrN), zirconium nitride (ZrN), aluminum nitride (AlN), tungsten (W), tungsten nitride (WN), molybdenum (Mo), and molybdenum nitride (Mo₂N). The ferroelectric thin film 410 has the characteristic that electric polarization occurs inside when an electric field is applied, and the polarization remains even when the electric field is removed.

In this case, a bias voltage of -5 V or higher and +5 V or lower may be applied to the ferroelectric capacitor 400. The ferroelectric capacitor 400 is formed on the back surface of the channel structure 300 and may change a threshold voltage by the body effect. That is, the threshold voltage may change by the ferroelectric capacitor 400 to secure a memory window of the semiconductor memory device. In this case, the body effect coefficient indicating the degree to which the threshold voltage changes by the body effect may be proportional to the thickness of the gate dielectric film.

In addition, the ferroelectric capacitor 400 may perform a general flash memory operation when the electrode is maintained in a grounded state (=0 V). In this case, while the inversion layer is not formed in the channel structure 300, an electric field may be instantaneously formed on the ferroelectric capacitor 400 side due to a potential increase on the channel structure 300. In other words, both polarization switching within the ferroelectric and a charge capture mechanism used in a general flash memory may be used.

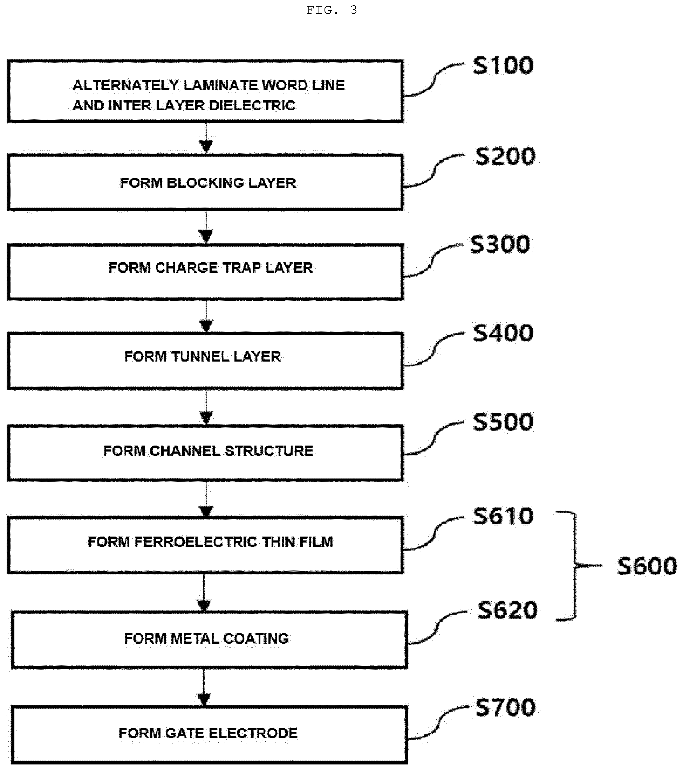

FIG. 3 is a flowchart illustrating a manufacturing sequence of the semiconductor memory device according to an embodiment of the present invention.

Referring to FIG. 3, a manufacturing method of a semiconductor memory device according to an embodiment of the present invention may include forming the laminated structure 100 by alternately laminating the word line 110 and the inter layer dielectric 120 (S100), forming the blocking layer 230 (S200), forming the charge trap layer 220 (S300), forming the tunnel layer 210 (S400), forming the channel structure 300 (S500), forming the ferroelectric capacitor (S600), and forming the gate electrode (S700).

In step S100, the laminated structure 100 may be formed by alternately laminating the word line 110 and the inter layer dielectric 120. The word line 110 of the semiconductor memory may be repeatedly arranged in multiple layers in the laminated structure 100, and individually access memory cells of each layer. That is, the word line 110 may enable access specific cells in the laminated structure 100 in a vertical direction. The inter layer dielectric 120 may be located between the word lines 110 to prevent electrical interference between metal wirings. The inter layer dielectric 120 may be made of a material such as SiO₂ or SiCOH.

Steps S200 to S500 may follow a general semiconductor memory device process. In step S500, the channel structure 200 may include one of a polysilicon channel or an oxide semiconductor channel.

In step S600, the ferroelectric capacitor 400 may be formed on the inner circumferential surface of the channel structure 300. In this case, the manufacturing method may include the step (S610) of forming the ferroelectric thin film 410 on the inner circumferential surface of the channel structure 300 and the step (S620) of forming the metal coating 420 on the inner circumferential surface of the ferroelectric thin film 410. The ferroelectric thin film 410 may include hafnium oxide (HfO₂), an insulating thin film in which at least one element of Al, Zr, La, Si, Gd, Sc, Y, Ge, N is included in the HfO₂, and at least one of zirconium oxide (ZrO₂), aluminum oxide (Al₂O₃), and barium strontium titanate (BST).

The metal coating 420 may include at least one of titanium nitride (TiN), tantalum nitride (TaN), chromium nitride (CrN), zirconium nitride (ZrN), aluminum nitride (AlN), tungsten (W), tungsten nitride (WN), molybdenum (Mo), and molybdenum nitride (Mo₂N).

In step S700, the thin film layer such as SiN included in the inter layer dielectric 120 may be removed and the metal may be deposited along the word line 110 to form the gate electrode.

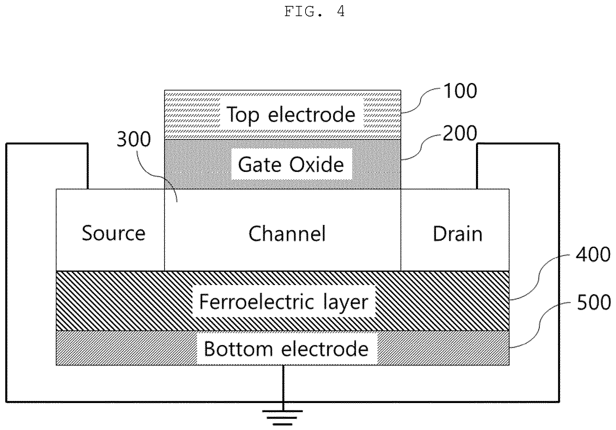

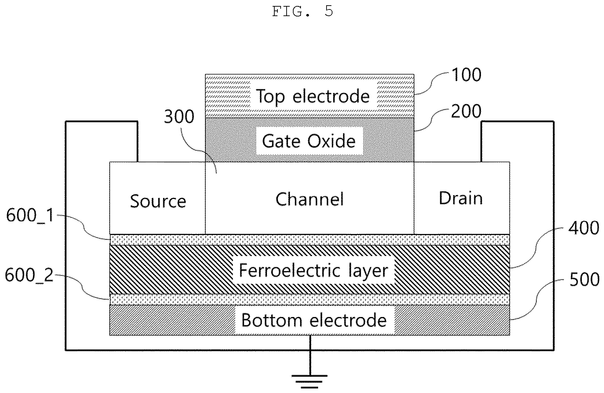

Figures 4 and 5 are plan views illustrating a part of a semiconductor memory device cut out according to an embodiment of the present disclosure.

Referring to FIG. 4, the semiconductor memory device according to an embodiment of the present invention may include the laminated structure 100, the vertical inter layer dielectric 200, the channel structure 300, the ferroelectric capacitor 400, and the bottom electrode 500. The semiconductor memory device may be connected to a positive terminal and a negative terminal of a power supply.

The laminated structure 100 may be connected to the positive terminal of the power supply and may be applied with a voltage. A program voltage VPGM and an erase voltage VERS may be applied to the laminated structure 100.

The vertical inter layer dielectric 200 may be formed on a lower surface portion of the laminated structure 100. The vertical inter layer dielectric 200 may include a blocking layer 230, a charge trap layer 220, and a tunnel layer 210. The vertical inter layer dielectric 200 may be formed by sequentially laminating the blocking layer 230, the charge trap layer 220, and the tunnel layer 210. The blocking layer 230, the charge trap layer 220, and the tunnel layer 210 included in the vertical inter layer dielectric 200 may be the same as the blocking layer, the charge trap layer, and the tunnel layer used in the general semiconductor memory device.

The channel structure 300 may be formed on a lower surface portion of the vertical inter layer dielectric 200 and connected to the substrate. The channel structure 300 may be composed of a general semiconductor material including single crystal silicon, polysilicon, or oxide semiconductor. The oxide semiconductor channel may include at least one of indium oxide (In₂O₃), zinc oxide (ZnO), gallium oxide (Ga₂O₃), indium zinc oxide (InZnO), zinc tin oxide (ZTO), and indium gallium zinc oxide (InGaZnO). In this case, the channel structure 300 may have a thickness greater than 0 nm and 100 nm or less to increase a threshold voltage.

Unlike the conventional semiconductor memory device, the ferroelectric capacitor 400 may be formed on a lower surface portion of the channel structure 300. The ferroelectric capacitor 400 may include a HfO₂ (hafnium oxide)-based ferroelectric material, a perovskite-based ferroelectric material including at least one of PbTiO₃, SrTiO₃, and CaTiO₃, and a two-dimensional material including at least one of α-In₂, Se₃, and SnS. In this case, in order to secure the ferroelectricity, when the ferroelectric capacitor 400 is made of the HfO₂ (hafnium oxide)-based ferroelectric material, the thickness may be greater than 0 nm and 30 nm or less. In addition, when the ferroelectric capacitor 400 is the perovskite-based ferroelectric material including at least one of PbTiO₃, SrTiO₃, and CaTiO₃, the thickness may be greater than 0 nm and 100 nm or less. The semiconductor memory device according to the present invention may prevent electrons from being captured in an interface layer by forming the ferroelectric capacitor 400 on the lower surface portion of the channel structure 300.

The bottom electrode 500 is formed on the lower surface portion of the ferroelectric capacitor 400 and may be connected to the negative terminal of the power supply. When the conventional ferroelectric capacitor is formed between the channel structure and the laminated structure, electrons in an inversion layer are captured by the interface layer during programming, thereby shortening the lifespan. In the semiconductor memory device structure of the present invention, the interface layer is located between the channel structure 300 and the ferroelectric capacitor 400, so the electron capture problems may not occur during the programming. In addition, since the direction of hole movement in the channel structure 300 is opposite to the direction where the interface layer is located during the erase operation, the hole capture may also not occur.

FIG. 5 is a plan view illustrating a configuration of a semiconductor memory device according to another embodiment of the present invention.

Referring to FIG. 5, the semiconductor memory device according to another embodiment of the present invention may include the laminated structure 100, the vertical inter layer dielectric 200, the channel structure 300, the ferroelectric capacitor 400, and the bottom electrode 500. The semiconductor memory device may be connected to a positive terminal and a negative terminal of a power supply. In addition, the semiconductor memory device according to another embodiment of the present invention may include a first thin film 600_1 and a second thin film 600_2.

The first thin film 600_1 may be formed between the channel structure 300 and the ferroelectric capacitor 400, and the second thin film 600_2 may be formed between the ferroelectric capacitor 400 and the bottom electrode 500. The semiconductor memory device according to the present invention may secure more memory windows by forming the first thin film 600_1 and the second thin film 600_2 to capture electrons.

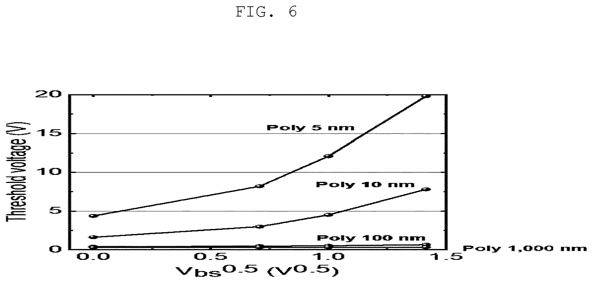

FIG. 6 is a graph showing a threshold voltage according to a thickness of a channel structure of the semiconductor memory device according to an embodiment of the present invention.

Referring to FIG. 6, it can be seen that the efficiency of the threshold voltage increases as the thickness of the channel structure 300 of the semiconductor memory device according to the embodiment of the present invention becomes thinner.

In particular, it can be confirmed that the threshold voltage change begins to increase gradually when the thickness of the channel structure 300 is 100 nm or less. When the thickness of the channel structure 300 is sufficiently thin, the channel structure 300 becomes a fully-depleted state, which has the effect of increasing the threshold voltage.

According to the present invention, it is possible to secure the memory window of the semiconductor memory device.

In addition, according to the present invention, it is possible to form the ferroelectric capacitor on the back surface of the channel structure to change the threshold voltage.

In addition, according to the present invention, it is possible to extend the life of the semiconductor memory device by preventing the electrons from being captured in the interface layer of the semiconductor memory device.

In addition, according to the present invention, it is possible to secure the higher memory window.

In addition, according to the present invention, it is possible to improve the data retention characteristics.

Although preferred embodiments of the present invention have been described above, the embodiments disclosed in the present invention are only for explaining, not limiting, the technical spirit of the present invention. Therefore, the technical idea of the present invention includes not only each disclosed embodiment but also a combination of the disclosed embodiments, and furthermore, the scope of the technical idea of the present invention is not limited by these embodiments. In addition, many modifications and alterations of the present disclosure may be made by those skilled in the art to which the present disclosure pertains without departing from the spirit and scope of the accompanying claims. In addition, it is to be considered that all of these modifications and alterations fall within the scope of the present disclosure.

## Claims

1. A semiconductor memory device, comprising:
a laminated structure that includes word lines and inter layer dielectrics laminated on a substrate alternately and repeatedly;
a channel structure that penetrates through the laminated structure and is connected to the substrate;
a vertical inter layer dielectric that is interposed between the laminated structure and the channel structure, and includes a tunnel layer in contact with the channel structure, a blocking layer in contact with the laminated structure, and a charge trap layer interposed between the tunnel layer and the blocking layer; and
a ferroelectric capacitor that is connected to an inner side surface of the channel structure to form an electrode,
wherein the ferroelectric capacitor includes a ferroelectric thin film and a metal coating.

2. The semiconductor memory device of claim 1, wherein the ferroelectric capacitor is formed such that one side of a ferroelectric thin film is connected to the channel structure, and the metal coating is connected to the other side of the ferroelectric thin film.

3. The semiconductor memory device of claim 2, wherein the ferroelectric thin film includes hafnium oxide (HfO₂), an insulating thin film in which at least one element of Al, Zr, La, Si, Gd, Sc, Y, Ge, N is included in the HfO₂, and at least one of zirconium oxide (ZrO₂), aluminum oxide (Al₂O₃), and barium strontium titanate (BST).

4. The semiconductor memory device of claim 2, wherein the metal coating includes at least one of titanium nitride (TiN), tantalum nitride (TaN), chromium nitride (CrN), zirconium nitride (ZrN), aluminum nitride (AlN), tungsten (W), tungsten nitride (WN), molybdenum (Mo), and molybdenum nitride (Mo₂N).

5. The semiconductor memory device of claim 1, wherein a bias voltage of -5 V or higher and +5 V or lower is applied to the ferroelectric capacitor.

6. The semiconductor memory device of claim 1, wherein the ferroelectric thin film has a thickness of 10 nm or less.

7. A semiconductor memory device connected to a positive terminal and a negative terminal of a power supply, comprising:
a laminated structure connected to the positive terminal of the power supply and applied with a voltage;
a vertical inter layer dielectric formed on a lower surface portion of the laminated structure;
a channel structure formed on a lower surface portion of the vertical inter layer dielectric and connected to a substrate;
a ferroelectric capacitor formed on a lower surface portion of the channel structure; and
a bottom electrode formed on a lower surface portion of the ferroelectric capacitor and connected to the negative terminal of the power supply.

8. The semiconductor memory device of claim 7, wherein the ferroelectric capacitor includes a ferroelectric material based on HfO₂ (hafnium oxide).

9. The semiconductor memory device of claim 8, wherein a ferroelectric material based on the HfO₂ (hafnium oxide) has a thickness greater than 0 nm and 30 nm or less.

10. The semiconductor memory device of claim 7, wherein the ferroelectric capacitor includes a perovskite-based ferroelectric material including at least one of PbTiO₃, SrTiO₃, and CaTiO₃.

11. The semiconductor memory device of claim 10, wherein the perovskite-based ferroelectric material including at least one of PbTiO₃, SrTiO₃, and CaTiO₃ has a thickness greater than 0 nm and 100 nm or less.

12. The semiconductor memory device of claim 7, wherein the ferroelectric capacitor includes a two-dimensional material including at least one of α-In₂, Se₃, and SnS.

13. The semiconductor memory device of claim 7, wherein the channel structure has a thickness greater than 0 nm and 100 nm or less.

14. The semiconductor memory device of claim 7, further comprising:
a first thin film formed between the channel structure and the ferroelectric capacitor; and
a second thin film formed between the ferroelectric capacitor and the bottom electrode.

15. A manufacturing method of a semiconductor memory device, comprising:
(a) forming a laminated structure by alternately laminating a word line and an inter layer dielectric;
(b) forming a cylindrical hole in the laminated structure and forming a blocking layer on an inner circumferential surface of the hole;
(c) forming a charge trap layer on an inner circumferential surface of the blocking layer;
(d) forming a tunnel layer on an inner circumferential surface of the charge trap layer;
(e) forming a channel structure on an inner circumferential surface of the tunnel layer;
(f) forming a ferroelectric capacitor on an inner circumferential surface of the channel structure; and
(g) removing a thin film layer included in the inter layer dielectric and depositing a metal along the word line to form a gate electrode.

16. The manufacturing method of claim 15, wherein the (f) includes:
(f-1) forming a ferroelectric thin film on the inner circumferential surface of the channel structure; and
(f-2) forming a metal coating on an inner circumferential surface of the ferroelectric thin film.

17. The manufacturing method of claim 16, wherein in the (f-1), the ferroelectric thin film includes hafnium oxide (HfO₂), an insulating thin film in which at least one element of Al, Zr, La, Si, Gd, Sc, Y, Ge, N is included in the HfO₂, and at least one of zirconium oxide (ZrO₂), aluminum oxide (Al₂O₃), and barium strontium titanate (BST).

18. The manufacturing method of claim 16, wherein in the (f-2), the metal coating includes at least one of titanium nitride (TiN), tantalum nitride (TaN), chromium nitride (CrN), zirconium nitride (ZrN), aluminum nitride (AlN), tungsten (W), tungsten nitride (WN), molybdenum (Mo), and molybdenum nitride (Mo₂N).
